Europäisches Patentamt

European Patent Office

Office européen des brevets

(19)

(11) Publication number: **0 110 320**
**B1**

## (12) EUROPEAN PATENT SPECIFICATION

(45) Date of publication of patent specification: **11.03.87**

(51) Int. Cl.⁴: **H 01 L 29/08, H 01 L 29/78**

(21) Application number: **83111730.4**

(22) Date of filing: **23.11.83**

(54) **A MOS transistor.**

(30) Priority: **27.11.82 JP 208294/82**
**30.11.82 JP 209989/82**

(43) Date of publication of application:
**13.06.84 Bulletin 84/24**

(45) Publication of the grant of the patent:
**11.03.87 Bulletin 87/11**

(84) Designated Contracting States:
**DE FR GB**

(56) References cited:
**DE-A-1 811 492**
**GB-A-2 011 178**
**US-A-3 821 776**
**US-A-3 999 210**
**US-A-4 011 576**

**IEEE Ind. Appl. Soc. Meeting, 1980, pp. 664-675**

**IEEE Transactions on Electron Devices, vol.
ED-27, No.2, pp. 399-400, Febr. 1980**

(73) Proprietor: **NISSAN MOTOR CO., LTD.**
**No.2, Takara-cho, Kanagawa-ku**
**Yokohama-shi Kanagawa-ken 221 (JP)**

(72) Inventor: **Mihara, Teruyoshi c/o Tatenoshataku
13-305
1-16, Futaba, Yokosuka-shi
Kanagawa-ken (JP)**

(74) Representative: **Patentanwälte Grünecker, Dr.
Kinkeldey, Dr. Stockmair, Dr. Schumann, Jakob,
Dr. Bezold, Meister, Hilgers, Dr. Meyer-Plath
Maximilianstrasse 58
D-8000 München 22 (DE)**

Courier Press, Leamington Spa, England.

## Description

The invention relates to MOS transistors as described in the preambles of claims 1 and 6, respectively.

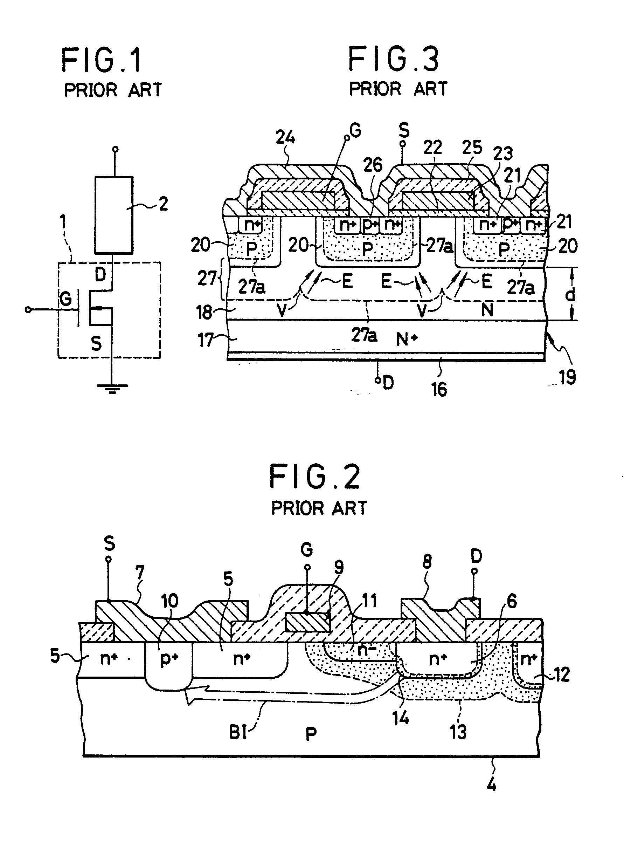

Prior art as described in connection with Figures 1 and 3 is disclosed in IEEE Ind. Appl. Soc. Meet., 1980, pp. 664—675. In IEEE Transactions on Electron Devices, Vol. ED-27, No. 2, February 1980, describes prior art as shown in Figure 2.

In recent years, MOS power transistors have appeared. As a result, a MOS transistor 1 has been put into use as a switching element for a power load 2 as shown in Fig. 1. For a vehicle, for example, it has been proposed to apply a MOS transistor to switching of various power loads mounted on vehicles.

Fig. 2 shows an example of structure of a conventional MOS transistor. The MOS transistor illustrated in Fig. 2 is a so-called lateral-type n-channel MOS transistor. The MOS transistor has on one main surface side of a p-type semiconductor substrate 4, an $n^+$-type source diffused region 5, an $n^+$-type drain diffused region 6, source and drain electrode 7, 8 made of aluminium respectively, and a gate electrode 9 placed between the source electrode 7 and the drain electrode 8.

Under the above described source electrode 7, a $p^+$-type substrate contact region 10 is formed. The source electrode 7 becomes a common electrode which also functions as a substrate electrode.

For the MOS power transistor as described above, various contrivances for raising the resistance to the high voltage have been made under the necessity of switching of rather high voltage and high current. In the MOS transistor illustrated in Fig. 2, it is contrived to raise the resistance to the high voltage by forming a guard ring 12 and an $n^-$-type drift region 11 which extends from the side of the drain diffusion region 6 toward the gate. If the above described power load 2 is an inductive load having a large inductance such as a motor or a solenoid, however, since the resistance to the high voltage of a conventional MOS transistor is not large enough to withstand a surge such as generated when the load current is interrupted, breakdown might occur resulting in degradation in the characteristics of the device or damage thereto.

This will now be described more concretely referring to Fig. 2. Assuming now that a high voltage surge is applied between the drain and the source, a depletion layer 13 is generated along the junction between the drain diffusion region 6 and the substrate 4.

At this time, probability of occurrence of punchthrough is lowered owing to the above described drift region 11 or guard ring 12. Due to a high voltage surge, breakdown might occur on a part having a comparatively large curvature (hereafter referred to as an edge portion) located on the periphery of the bottom of the drain diffusion region 6, especially on an edge portion 14 located near the gate G. This is because the electric field applied to the depletion layer converges at a portion having a small radius of curvature.

Since the breakdown current BI flows through a narrow region in the vicinity of the edge portion 14, the heat convergence might cause damage to the device. Especially the gate G is often subjected to thermal damage because the breakdown current BI flows near the surface of the substrate 4.

A similar problem is found in a vertical-type MOS transistor as well. Fig. 3 is a sectional view of an example of a vertical-type MOS transistor.

This device basically includes a semiconductor substrate 19 composed of a lower $n^+$-type low-resistivity region 17 having a flat upper surface whereto a drain electrode 16 is joined and an upper n-type high-resistivity region 18, a plurality of p-type well regions 20 which have conductivity types opposite that of said substrate 19 and are formed at predetermined interval within said n-type region 18 located on the upper surface side of the substrate 19, an $n^+$-type source region 21 formed within said p-type well region 20, and a gate electrode 23 formed on surfaces of the substrate 19 and the well regions 20 through a gate oxide film 22 which is an insulative film while extending over both the $n^+$-type source region 21 and said n-type region 18 of the substrate 19 which substantially functions as a drain region.

The upper surface of the gate electrode 23 except for the leading-out port is coated with a PSG (Phospho-Silicate glass) film 25. And a source electrode 24 is joined to the source region 21 as well as a $p^+$-type contact region 26 which is formed within a p-type well region 20.

When a voltage is applied between the drain and the source in a reverse direction of the p-n junction, a depletion layer is produced along the junction face between the drain region 18 and the well region 20. In Fig. 2, the region of the depletion layer 27 is represented by dotted lines 27a. This depletion layer 27 is widened as the voltage between the drain and the source is increased.

It should be noted for the conventional MOS transistor illustrated in Fig. 3 that avalanche breakdown occurs on the junction between the n-type drain region 18 and the well region 20 before the depletion layer 27 widening into the n-type drain region 18 reaches the $n^+$-type drain region 17 and the current under the avalanche breakdown state is apt to converge to a limited part. When the avalanche breakdown is caused by a surge voltage, the breakdown current flowing between the drain and source converges to a limited part within the device even if the current is rather low. As a result, heat generation caused by current flow converges upon a part, therefor the device is damaged.

This phenomenon will now be described in detail. When the depletion layer 27 is not largely spread out as represented by the dotted lines 27a in Fig. 3, valleys V corresponding to two adjacent well regions 20 are generated in the depletion layer 27 existing in the n-type drain region 18. As indicated by an arrow E, the electric field applied to the depletion layer 27 is apt to converge upon a part located between the valleys V of the depletion layer 27 and a corner of the well region 20. If the electric field applied to the depletion layer 27 is thus concentrated on a limited part, the current flow under the avalanche state is also concentrated on that part. And the heat generated by the concentrated current damages the device.

The task to be solved by the invention is to improve MOS transistors according to the preambles of claims 1 and 6, respectively such that the breakdown current caused by a surge or the like does not readily incur the thermal breakdown of the device.

This task is solved in accordance with the invention by the features comprised by the characterising portions of claims 1 and 6, respectively.

The MOS transistors according to the invention have the advantage that a breakdown current caused by a surge or the like does not converge to a limited part within the device but flows uniformally through a rather broad part. Accordingly, there is no heat concentration incurred, whereby a damage to the device due to breakdown is prevented.

Advantageous embodiments are claimed by the subclaims.

Embodiments for carrying out the invention are described in detail below with reference to the Figures shown in the drawings.

Fig. 1 is a circuit diagram of a switching circuit using a MOS transistor.

Fig. 2 is a sectional view of a structure of a lateral-type MOS transistor according to the prior art.

Fig. 3 is a sectional view of a structure of a vertical-type MOS transistor according to the prior art.

Fig. 4 is a sectional view of an embodiment of a lateral-type MOS transistor according to the present invention.

Fig. 5 is a sectional view of an embodiment of a vertical-type MOS transistor according to the present invention.

Detailed Description of the Invention

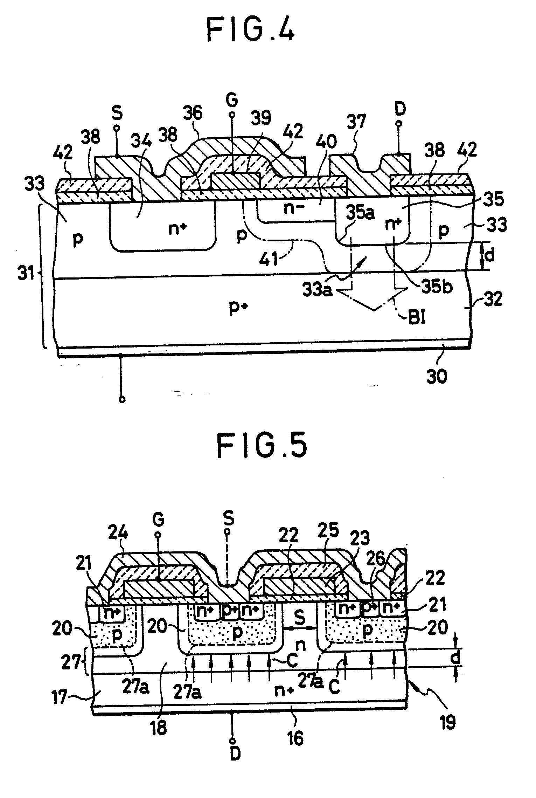

An embodiment of a MOS transistor according to the present invention will now be described in detail by referring to Fig. 4.

In the embodiment of the MOS transistor illustrated in Fig. 4, onto a $p^+$-type low-resistivity layer 32 electrically connected to a substrate electrode 30, a p-type high-resistivity layer 33 which is lower than the $p^+$-type layer 32 in impurity concentration is formed by means of epitaxial growth to provide a laminated substrate 31.

On the above described p-type layer 33, an $n^+$-type source diffused region 34 and an $n^+$-type drain diffused region 35 are formed by means of diffusion. A source electrode 36 and a drain electrode 37 are provided by patterning of aluminium respectively on the source diffused region 34 and the drain diffused region 35. Between the source electrode 36 and the drain electrode 37, a gate electrode 39 is formed so as to be insulated from the p-type layer 33 and the source electrode 36 by an oxide film 38 and phosphorus glass 42. The thickness $d$ and resistivity which depends upon the impurity concentration of a thin portion of the p-type region 33a existing between the drain diffusion region 35 and the $p^+$-type layer 32 are determined so as to bring about reach-through breakdown.

An $n^-$-type drift region 40 in Fig. 4 is provided for the purpose of raising the punch-through voltage like the drift region 11 illustrated in Fig. 2. In general, the source electrode 36 is electrically connected to the substrate electrode 30. The source and substrate electrodes are used as a common electrode.

The aforementioned reach-through breakdown will now be described. When a voltage $V_R$ is applied to a p-n junction of a semiconductor in the reverse direction, it is known that the width W of the spread of the depletion layer from the junction face may be expressed as

$$W = \sqrt{\frac{2\,\epsilon\,\epsilon_0\,|V_R|}{q\,Ni}} \qquad (1)$$

where $\epsilon$ is the relative dielectric constant of the semiconductor, $\epsilon_0$ is the dielectric constant of vacuum, q is the electric charge of an electron, and Ni is the impurity concentration of the semiconductor.

Assuming that the $p^+$-type layer 32 is absent in the MOS transistor illustrated in Fig. 4 and the breakdown voltage at an edge portion 35a having impurity concentration $N_A$ on the periphery of the bottom of the drain diffusion region 35 is BV, it is apparent from the expression (1) that the spread width $W_B$ of the depletion layer 41 may be approximately expressed as

$$W_B = \sqrt{\frac{2\,\epsilon\,\epsilon_0\,|BV|}{q\,N_A}} \qquad (2)$$

When the thickness $d$ of the above described narrow portion 33a is chosen to be more than the spread width $W_B$, i.e., $d \geqq W_B$, and a high voltage is applied to a drain D illustrated in Fig. 4, the depletion layer 41 does not spread out beyond the thickness $d$ of the thin portion 33a of the p-type region 33. As the applied voltage is further raised, the depletion layer 41 is spread out along the upper surface of the $p^+$-type region layer 32. And when the applied voltage has reached certain voltage which is higher than the above described breakdown voltage BV, breakdown or reach-through breakdown occurs on a bottom surface 35b of the above described drain diffused region 35.

The breakdown current BI caused by the reach-through breakdown flows through a wide area within the bottom surface 35b of the drain diffused region 35 and through the $p^+$-type layer 32. Accordingly, heat concentration is not incurred, preventing damage to the device due to breakdown.

As evident from the expression (2), the spread width of the depletion layer in the above described MOS transistor depends upon the impurity concentration $N_A$ of the thin portion region 33a, i.e., the p-type layer 33. Accordingly, it is possible to construct so that the depletion layer in the p-type layer 33 reaches the p$^+$-type layer 32 before a breakdown occurs by changing the impurity concentration $N_A$ instead of the thickness $d$ of the p-type region 33a.

An embodiment of a lateral-type MOS transistor according to the present invention has heretofore been described. However, the same principle can be applied to a vertical-type MOS transistor.

Fig. 5 shows an embodiment of a vertical-type MOS transistor according to the present invention.

The basis structure of this MOS transistor is the same as that of the MOS transistor according to the prior art illustrated in Fig. 3. An identical component is denoted by the same numeral or symbol as that used in Fig. 3.

This device basically includes a semiconductor substrate 19 composed of a lower n$^+$-type low-resistivity region 17 having a flat lower surface whereto a drain electrode 16 is joined and an upper n-type high-resistivity region 18, a plurality of p-type well regions 20 which have conductivity types opposite that of said substrate 19 and are formed at predetermined interval within said n-type region 18 located on the upper surface side of the substrate 19, an n$^+$-type source region 21 formed within said p-type well region 20, and a gate electrode 23 formed on surfaces of the substrate 19 and the well regions 20 through a gate oxide film 22 which is an insulative film while extending over both the n$^+$-type source region 21 and said n-type region 18 of the substrate 19 which substantially functions as a drain region. The upper surface of the gate electrode 23 except for the leading-out port is coated with a PSG (Phospho-Silicate glass) film 25. And a source electrode 24 is joined to the source region 21 as well as a p$^+$-type contact region 26 which is formed within the p-type well region 20.

A feature of the MOS transistor described in Fig. 5 different from conventional one described in Fig. 3 is that the impurity concentration $N_D$ and thickness $d$ defining the resistivity of the n-type drain region 18 put between the p-type well region 20 and the n$^+$-type drain region 17 are chosen to satisfy the relation

$$d \leqq \sqrt{\frac{2\,\epsilon\epsilon_{\bullet}\,|\,BV\,|}{q \cdot N_D}} \qquad (3)$$

so that reach-through breakdown may occur between the p-type well region 20 and the n$^+$-type drain region 17.

The expression (3) and the foregoing description relating to the expression (1) and (2) reveal that avalanche breakdown of the p-n junction never occur in the MOS transistor according to the present invention when the boundary surface of a depletion layer 27 extending from the junction between the n-type drain region 18 and the well region 20 exists in the n-type drain region 18 having a thickness of $d$. That is to say, without causing the avalanche breakdown, the depletion layer 27 extending from the above described p-n junction face passes through the n-type drain region 18 and reaches the n$^+$-type drain region 17 (reach-through phenomenon).

Even if the voltage applied between the drain and source is further increased after the depletion layer 27 has reached the n$^+$-type drain region 17, the depletion layer 27 hardly advances beyond the boundary face between the n-type drain region 18 and the n$^+$-type drain region 17 into the region 17. If the voltage between the drain and source is further increased, breakdown occurs between the n$^+$-type drain region 17 and the well-region 20. This is the so-called reach-through breakdown.

It should be noted that when the depletion layer 27 has reached the n$^+$-type drain region 17, the boundary surface of the depletion layer 27 forms a plane which nearly coincides with the boundary face between the n-type region 18 and the n$^+$-type 17 and a valley V of the depletion layer 27 illustrated in Fig. 3 of the prior art is not produced. Therefore, the electric field applied to the depletion layer 27 is uniformly distributed over nearly entire surface of the bottom of the well region 20 as represented by arrows C. Thus, the electric field does not converge to a limited part unlike the prior art.

Under such a state, breakdown occurs. Accordingly, the breakdown current flowing from the n$^+$-type drain region 17 toward the bottom of the well region 20 is also distributed over a wide area nearly uniformly. Thus, the concentration of breakdown current upon the corner of the well region found in the prior art is prevented. Even if a comparatively large breakdown current flows, therefore, heat generation is not limited to a part. As a result, thermal damage to the device is prevented.

An example will now be described by using practical values. For a MOS transistor of the prior art having the surface concentration of the p-type well region 20 of $1 \times 10^{18}$/cm$^3$, its diffusion depth of 5 μm, the space between two adjacent well regions 20 of 10 μm, the resistivity value of the high-resistivity drain region 18 of 2.5 Ωcm, and sufficiently large thickness $d$ of the n-type drain region 18, it has been experimentally observed that the voltage BV at which avalanche breakdown is incurred between the n-type drain region 18 and the well region 20 is 160 volts and then the spread width $W_B$ of the depletion layer extending from the p-n junction face toward the drain region 18 is approximately 10 μm.

For a MOS transistor according to the present invention having the same factors as the above described MOS transistor of the prior art excepting the thickness $d$ of the n-type drain region 18 chosen to be 5 µm which is approximately the half of the value of $W_B$, the depletion layer 27 reaches the n$^+$-type drain region 17 when the voltage between the drain and the source is raised to approximately 40 volts, further extension being stopped. If the voltage is further increased, all of the valleys V of the depletion layer 27 as seen in Fig. 3 of the prior art reach the n$^+$-type drain region 17 and the depletion layer exhibits a plane at the boundary between the n$^+$-type drain region 17 and the n-type drain region 18. Raising the voltage to approximately 80 volts causes reach-through breakdown between the N$^+$-type drain region 17 and the well region 20. At this time, the breakdown current flows through the nearly entire region of the bottom of the well region 20. Accordingly, current distribution is significantly improved as compared with the prior art, sufficient surge durability being attained.

In the above example, only the thickness $d$ of the n-type drain region 18 between the n$^+$-type drain region 17 and the well region 20 is reduced without changing the impurity concentration of the n-type drain region 18 to satisfy the expression (3). When the resistance to the voltage is not desired to be lowered, it is possible to satisfy the expression (3) by reducing the impurity concentration $N_D$ in order to increase the resistivity without changing the thickness $d$. As a result, reach-through breakdown is readily incurred.

Both the prior art and embodiments of the present invention have heretofore been described by referring to n-channel MOS transistors. However, it is a matter of course that the present invention may be similarly applied to a p-channel, MOS transistor as well.

In addition, the present invention is not restricted to a MOS transistor having the illustrated structure, but may be applied to MOS transistors having other structures such as a VMOS transistor.

As heretofore been described in detail, even if a high voltage due to a surge or the like is applied between the drain and source of a MOS transistor according to the present invention and thereby breakdown is incurred, the breakdown current does not converge to a limited part within the device but flows through a wide area nearly uniformly. Therefore, the device is not readily subjected to thermal damage, sufficient surge durability being attained. Thus, the present invention provides a device suitable for switching an inductive load. In addition, the necessity of providing an external zener diode for protecting the device is eliminated.

## Claims

1. A MOS transistor comprising:
a low-resistivity layer (32) of a first conductivity type provided with a substrate electrode (30) on a lower surface thereof,
a high-resistivity layer (33) of said first conductivity type formed on said low-resistivity layer (32),
a source region (34) of a second conductivity type opposite said first conductivity type formed in said high-resistivity layer (33) at the upper side thereof.
a drain region (35) of said second conductivity type formed in said high-resistivity layer (33) apart from said source region (34) at the upper side thereof,
said source and drain regions (34, 35) provided with electrodes (36, 37) respectively on upper surfaces thereof,
a gate electrode (39) formed on a surface of said high-resistivity layer (33) between said source and drain regions (34, 35) through an insulative film (38) extending over both said source and drain regions (34, 35), characterised in that the value of the impurity concentration and the thickness (d) of a part (33a) of said high-resistivity layer (33) existing between the bottom surface of said drain region (35) and the upper surface of said low-resistivity layer (32) are chosen such that at or above the breakdown voltage the boundary surface of said depletion layer (27) associated with said drain region (35) and said part (33a) of said high-resistivity layer (32) between said drain region (35) and the upper surface of said low-resistivity layer (32) forms a surface which nearly coincides with the boundary face between said high-resistivity and low-resistivity layers (33, 32).

2. The MOS transistor claimed in claim 1, wherein,
said impurity concentration and thickness (d) of said part (33a) of said high-resistivity layer (33) existing between the bottom surface of said drain region (35) and the upper surface of said low-resistivity layer (32) satisfy the condition

$$d \leqq \sqrt{\frac{2\epsilon\epsilon_0 \left| BV \right|}{q \cdot N_D}}$$

wherein $N_D$ is said impurity concentration, d is said thickness, $\epsilon$ is relative dielectric constant of said high-resistivity layer, $\epsilon_0$ is the dielectric constant of vacuum, BV is the breakdown voltage of said high-resistivity layer, and q is the electric charge of an electron.

3. The MOS transistor claimed in claim 2, wherein,
said source electrode (36) is electrically connected to said substrate electrode (30).

4. The MOS transistor claimed in claim 2, wherein,
said high-resistivity layer (33) is formed by means of epitaxial growth on said low-resistivity layer (32), and said source and drain regions (34, 35) are formed by means of diffusion on said high-resistivity layer (33).

5. The MOS transistor claimed in claim 2, wherein,
said drain region (35) is provided with a drift region (40) on said second conductivity type having impurity concentration lower than that of said drain region (35), and said drift region (40) extends from the side of said drain region (35) toward the gate region.

6. A MOS transistor comprising;
a low-resistivity layer (17) of a first conductivity type provided with a drain electrode (16) on a lower surface thereof,
a high-resistivity layer (18) of said first conductivity type formed on an upper surface of said low-resistivity layer (17),
a well region (20) of second conductivity type opposite said first conductivity type formed in said high-resistivity layer (18) at an upper side thereof,
a source region (21) of said first conductivity type formed in said well region (20) at an upper side thereof and provided with a source electrode (24),
a gate electrode (23) formed on the surface of said well region (20) through an insulative layer (22), characterised in that said impurity concentration and thickness (d) of a part of said high-resistivity layer (17) existing between the bottom surface of said well region (20) and the upper surface of said low-resistivity layer (17) are chosen such that at or above the breakdown voltage the boundary surface of the depletion layer (27) associated with said well region (20) and a part of said high-resistivity layer (18) between said well region (20) and the upper surface of said low-resistivity layer (17) forms a surface which nearly coincides with the boundary face between said high-resistivity and low-resistivity layers (17, 18).

7. The MOS transistor claimed in claim 6, wherein,
said impurity concentration and thickness (d) of said part of said high-resistivity layer (18) existing between the bottom surface of said well region (20) and the upper surface of said low-resistivity layer (17) satisfy the condition

$$d \leqq \sqrt{\frac{2 \epsilon \epsilon_0 |BV|}{q \cdot N_D}}$$

wherein $N_D$ is said impurity concentration, d is said thickness, $\epsilon$ is relative dielectric constant of said high-resistivity layer, $\epsilon_0$ is the dielectric constant of vacuum, BV is the breakdown voltage of said high-resistivity layer, and q is the electric charge of an electron.

8. The MOS transistor claimed in claim 7 wherein,
said source electrode (24) comes in contact with a contact region of said second conductivity type (26) which is formed in said well region (20).

## Patentansprüche

1. MOS-Transistor mit:
einer Schicht (32) mit geringem spezifischen Widerstand aus einer ersten Leitfähigkeitsart, die auf einer unteren Oberfläche mit einer Substratelektrode (30) versehen ist,

einer Schicht (33) mit hohem spezifischen Widerstand aus der ersten Leitfähigkeitsart, die auf der Schicht (32) mit geringem spezifischen Widerstand gebildet ist,
einem Source-Bereich (34) aus einem zu der ersten Leitfähigkeitsart entgegengesetzten, zweiten Leitfähigkeitsart, der in der Schicht (33) mit hohem spezifischen Widerstand an deren Oberseite gebildet ist,
einem Drain-Bereich (35) aus der zweiten Leitfähigkeitsart, der in der Schicht (33) mit hohem spezifischen Widerstand an ihrer oberen Seite von dem Source-Bereich (34) getrennt gebildet ist,
wobei der Source- und Drain-Bereich (34, 35) an ihren oberen Oberflächen mit Elektroden (36, 37) versehen sind,
einer Gate-Elektrode (39), die an einer Oberfläche der Schicht (33) mit hohem spezifischen Widerstand zwischen dem Source- und dem Drain-Bereich (34, 35) über einer dünnen Isolierschicht (38) gebildet ist, die sich über den Source- und den Drain-Bereich (34, 35) erstreckt, dadurch gekennzeichnet, daß der Wert der Verunreinigungskonzentration und die Dicke (d) eines Teils (33a) der Schicht (33) mit hohem spezifischen Widerstand, der zwischen der Bodenfläche des Drain-Bereichs (35) und der oberen Oberfläche der Schicht (32) mit niederem spezifischen Widerstand vorliegt, derart gewählt sind, daß bei oder oberhalb der Durchbruchspannung die Grenzfläche der Verarmungsschicht (27), die dem Drain-Bereich (35) und dem Teil (33a) der Schicht (32) mit hohem spezifischen Widerstand zwischen dem Drain-Bereich (35) und der oberen Oberfläche der Schicht (32) mit geringem spezifischen Widerstand zugeordnet ist, eine Oberfläche bildet, die nahezu mit der Grenzfläche zwischen der Schicht (33) mit hohem spezifischen Widerstand und der Schicht (32) mit niederem spezifischen Widerstand zusammenfällt.

2. MOS-Transistor nach Anspruch 1, bei dem die Verunreinigungskonzentration und die Dicke (d) des Teils (33a) der Schicht (33) mit hohem spezifischen Widerstand, der zwischen der Bodenoberfläche des Drain-Bereichs (35) und der oberen Oberfläche der Schicht (32) mit geringem spezifischen Widerstand vorliegt, die Bedingung erfüllt

$$d \leqq \sqrt{\frac{2 \epsilon \epsilon_0 |BV|}{q \cdot N_D}}$$

mit $N_D$ der Verunreinigungskonzentration, d der dicke, $\epsilon$ der spezifischen Dielektrizitätskonstanten der Schicht mit hohem spezifischen Widerstand, $\epsilon_0$ der Dielektrizitätskonstanten des Vakuums, BV der Durchbruchspannung der Schicht mit hohem spezifischen Widerstand und q der elektrischen Ladung des Elektrons.

3. MOS-Transistor nach Anspruch 2, bei dem die Source-Elektrode (36) elektrisch mit der Substrat-Elektrode (30) verbunden ist.

4. MOS-Transistor nach Anspruch 2, bei dem die Schicht (33) mit hohem spezifischen Widerstand durch Aufwachsen auf der Schicht (32) mit geringem spezifischen Widerstand gebildet ist, und der Source- und Drain-Bereich (34, 35) durch Diffusion auf der Schicht (33) mit hohem spezifischen Widerstand gebildet sind.

5. MOS-Transistor nach Anspruch 2, bei dem der Drain-Bereich (35) mit einem Drift-Bereich (40) auf der zweiten Leitfähigkeitsart versehen ist, der eine geringere Verunreinigungskonzentration als der Drain-Bereich (35) aufweist, und sich der Drift-Bereich (40) von der Seite des Drain-Bereiches (35) in Richtung zu dem Gate-Bereich erstreckt.

6. MOS-Transistor mit:

einer Schicht (17) mit geringem spezifischen Widerstand aus einer ersten Leitfähigkeitsart, die an ihrer unteren Oberfläche mit einer Drain-Elektrode (16) versehen ist,

einer Schicht (18) mit hohem spezifischen Widerstand aus der ersten Leitfähigkeitsart, die auf einer oberen Oberfläche der Schicht (17) mit geringem spezifischen Widerstand gebildet ist,

einem Vertiefungsbereich (20) aus einem zu der ersten Leitfähigkeitsart entgegengesetzten, zweiten Leitfähigkeitsart, der an einer oberen Seite der Schicht (18) mit hohem spezifischen Widerstand ausgebildet ist,

einem Source-Bereich (21) aus der ersten Leitfähigkeitsart, der in dem Vertiefungsbereich (20) an dessen einer oberen Seite ausgebildet und mit einer Source-Elektrode (24) versehen ist,

einer Gate-Elektrode (23), die auf der Oberfläche des Vertiefungsbereiches (20) über einer Isolierschicht (22) gebildet ist, dadurch gekennzeichnet, daß die Verunreinigungskonzentration und die Dicke d eines Teils der Schicht (17) mit hohem spezifischen Widerstand, der zwischen der Bodenoberfläche des Vertiefungsbereiches (20) und der oberen Oberfläche der Schicht (17) mit geringem spezifischen Widerstand vorliegt, derart gewählt sind, daß bei oder oberhalb der Durchbruchsspannung die Grenzoberfläche der Verarmungsschicht (27), die den Vertiefungsbereich (20) uind einem Teil der Schicht (18) mit hohem spezifischen Widerstand zwischen dem Vertiefungsbereich (20) und der oberen Oberfläche der Schicht (17) mit niederem spezifischen Widerstand zugeordnet ist, eine Oberfläche bildet, die nahezu mit der Grenzfläche zwischen der Schicht (17) mit hohem spezifischen Widerstand und der Schicht (18) mit niederem spezifischen Widerstand zusammenfällt.

7. MOS-Transistor nach Anspruch 6, bei dem die Verunreinigungskonzentration und die Dicke d des Teils der Schicht (18) mit hohem spezifischen Widerstand, der zwischen der Bodenoberfläche des Vertiefungsbereiches (20) und der oberen Oberfläche der Schicht (17) mit geringem spezifischen Widerstand vorliegt, die Bedingung erfüllt:

$$d \leqq \sqrt{\frac{2\epsilon\epsilon_0 |BV|}{q \cdot N_D}}$$

mit $N_D$ der Verunreinigungskonzentration, d der Dicke, ε der spezifischen Dielektrizitätskonstanten der Schicht mit hohem spezifischen Widerstand, $\epsilon_0$ der Dielektrizitätskonstanten des Vakuums, BV der Durchbruchspannung der Schicht mit hohem spezifischen Widerstand und q der elektrischen Ladung des Elektrons.

8. MOS-Transistor nach Anspruch 7, bei dem die Source-Elektrode (24) mit einem Kontaktbereich der zweiten Leitfähigkeitsart (26) in Berührung kommt die in dem Vertiefungsbereich (20) gebildet ist.

**Revendications**

1. Transistor MOS comprenant:

une couche (32) de faible résistivité d'un premier type de conductivité pourvue d'une électrode de substrat (30) sur sa surface inférieure,

une couche (33) de forte résistivité dudit premier type de conductivité formée sur ladite couche (32) de faible résistivité,

une région de source (34) d'un second type de conductivité, opposé audit premier type de conductivité, formée dans ladite couche de haute résistivité (33) à son côté supérieur,

une région de drain (35) dudit second type de conductivité, formée dans ladite couche de haute résistivité (33) séparée de ladite région de source (34) à son côté supérieur,

lesdites régions de source et de drain (34, 35) étant pourvues d'électrodes (36, 37) respectivement à leurs surfaces supérieures,

une électrode de porte (39) formée sur une surface de ladite couche de haute résistivité (33) entre lesdites régions de source et de drain (34, 35) par un film isolant (38) s'étendant sur lesdites deux régions de source et de drain (34, 35),

caractérisé en ce que la valeur de la concentration en impureté et de l'épaisseur (d) d'une partie (33a) de ladite couche (33) de haute résistivité existant entre la surface inférieure de ladite région de drain (35) et la surface supérieure de ladite couche (32) de faible résistivité sont choisies de manière qu'à ou au-delà de la tension de rupture, la surface limite de ladite couche d'épuisement (27) associée à ladite région de drain (35) et de ladite partie (33a) de ladite couche de haute résistivité (32) entre ladite région de drain (35) et la surface supérieure de ladite couche (32) de faible résistivité forme une surface qui coïncide presque avec la face limite entre lesdites couches de haute résistivité et de faible résistivité (33, 32).

2. Transistor MOS selon la revendication 1 où ladite concentration en impureté et l'épaisseur (d) de ladite partie (33a) de ladite couche de haute résistivité (33) existant entre la surface inférieure de ladite région de drain (35) et la surface supérieure de ladite couche de faible résistivité (32) satisfont à la condition

$$d \leqq \sqrt{\frac{2\epsilon\epsilon_0 |BV|}{q \cdot N_D}}$$

où $N_D$ est ladite concentration en impureté, d est ladite épaisseur, ε est la constante diélectrique relative de ladite couche de haute résistivité, $ε_o$ est la constante diélectrique du vide, BV est la tension de rupture de ladite couche de haute résistivité et q est la charge électrique d'un électron.

3. Transistor MOS selon la revendication 2, où ladite électrode de source (36) est électriquement connectée à ladite électrode de substrat (30).

4. Transistor MOS selon la revendication 2 où ladite couche (33) de haute résistivité est formée par croissance épitaxiée sur ladite couche de faible résistivité (32) et lesdites régions de source et de drain (34, 35) sont formées au moyen d'une diffusion sur ladite couche de haute résistivité (33).

5. Transistor MOS selon la revendication 2, où ladite région de drain (35) est pourvue d'une région de glissement (40) sur ledit second type de conductivité ayant une concentration en inpureté plus faible que celle de ladite région de drain (35) et ladite région de glissement (40) s'étend du côté de ladite région de drain (35) vers la région de porte.

6. Transistor MOS comprenant;
une couche (17) de faible résistivité d'un premier type de conductivité pourvue d'une électrode de drain (16) à sa surface inférieure,
une couche (18) de haute résistivité dudit premier type de conductivité formée sur une surface supérieure de ladite couche de faible conductivité (17),
une région de puits (20) d'un second type de conductivité, opposé audit premier type de conductivité, formée dans ladite couche de haute résistivité (18) à son côté supérieur,
une région de source (21) dudit premier type de conductivité formée dans ladite région de puits (20) à son côté supérieur et pourvue d'une électrode de source (24),

une électrode de porte (23) formée à la surface de ladite région de puits (20) à travers une couche isolante (22), caractérisé en ce que ladite concentration en impureté et l'épaisseur (d) d'une partie de ladite couche de haute résistivité (17) existant entre la surface inférieure de ladite région de puits (20) et la surface supérieure de ladite couche de faible résistivité (17) sont choisies de manière qu'à ou au-delà de la tension de rupture, la surface limite de la couche d'épuisement (27) associée à ladite région de puits (20) et une partie de ladite couche (18) de haute résistivité entre ladite région de puits (20) et la surface supérieure de ladite couche (17) de faible résistivité forme une surface qui coïncide presque avec la face limite entre lesdites couches de haute résistivité et de faible résistivité (17, 18).

7. Transistor MOS selon la revendication 6, où ladite concentration en impureté et l'épaisseur (d) de ladite partie de ladite couche de haute résistivité (18) existant entre la surface inférieure de ladite région de puits (20) et la surface supérieure de ladite couche (17) de faible résistivité satisfont à la condition

$$d \leqq \sqrt{\frac{2 \, \epsilon \, \epsilon_o |\mathrm{BV}|}{q \cdot N_D}}$$

où $N_D$ est ladite concentration en impureté, d est ladite épaisseur, ε est la constante diélectrique relative de ladite couche de haute résistivité, $ε_o$ est la constante diélectrique du vide, BV est la tension de rupture de ladite couche de haute résistivité et q est la charge électrique d'un électron.

8. Transistor MOS selon la revendication 7 où, ladite électrode de source (24) vient en contact avec une région de contact dudit second type de conductivité (26) qui est formée dans ladite région de puits (20).

# FIG.1
## PRIOR ART

# FIG.3
## PRIOR ART

# FIG.2
## PRIOR ART

# FIG.4

# FIG.5